# EUROPEAN PATENT APPLICATION

(11) **EP 4 672 896 A1**
(43) Date of publication of application: **31.12.2025**
(21) Application number: 25176029.4
(22) Date of filing: 13.05.2025
(51) Int. Cl.: H10D 1/68, H01L 23/522

(54) **METAL-INSULATOR-METAL (MIM) CAPACITOR ARCHITECTURES WITH LOW ELECTRICAL RESISTANCE**

(30) Priority: 28.06.2024 US 202418758907
(71) Applicant: INTEL Corporation, Santa Clara, CA 95054 (US)
(72) Inventor: Juengling, Werner, Rio Rancho, NM 87144 (US)
(74) Representative: Goddar, Heinz J.

(57) **Abstract**

Capacitor structures that include a cell metal-insulator-metal (MIM) stack within topographic cell containers and cell interconnects that couple the MIM stack of a plurality of cells in electrical parallel to shared capacitor terminals. A first cell interconnect of a first conductive material may span an area under a plurality of the cell containers and a second conductive material of the MIM stack that is confined as a liner of the cell containers is in contact with the first cell interconnect, thereby reducing an electrical resistance of a first shared capacitor electrode. An insulator and another conductive material of the MIM stack is formed within the plurality of cell containers. A second cell interconnect of another conductive material may span an area over a plurality of the cell containers to further couple the MIM stacks of a plurality of cells in electrical parallel to another shared capacitor terminal.

## Description

### BACKGROUND

Advanced integrated circuit (IC) devices rely on robust high-performance capacitors. In modern integrated circuits, such capacitors may take the form of metal-insulator-metal (MIM) capacitors, which may be integrated into a packaged IC die. Within an IC die package, one application of MIM capacitors is the conditioning of power supplied to an IC die, for example to remove ripple or other noise from a voltage regulator (VR). To increase charge capacitance per unit of IC die package area, a MIM thin film material stack may be formed over topographic features of high aspect-ratio. Unfortunately, the resulting increase in plate area of the MIM capacitor can be hindered by the plates having higher electrical resistance.

MIM capacitor architectures, and associated fabrication techniques, offering both a large plate area and low plate resistance are therefore commercially advantageous.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a flow diagram illustrating methods of forming a MIM capacitor, in accordance with some embodiments;
FIG. 2 is a cross-sectional view illustrating an electronic device that is to include a MIM capacitor, in accordance with some embodiments;
FIG. 3A and 3B are cross-sectional and plan views illustrating a MIM capacitor bottom cell interconnect structure, in accordance with some embodiments;
FIG. 4A and 4B are cross-sectional and plan views illustrating MIM capacitor cell structures, in accordance with some embodiments;
FIG. 5A and 5B are cross-sectional and plan views illustrating formation of a MIM capacitor cell bottom electrode, in accordance with some embodiments;
FIG. 6A and 6B are cross-sectional and plan views illustrating a patterning of the MIM capacitor cell bottom electrode, in accordance with some embodiments;
FIG. 7A and 7B are cross-sectional and plan views illustrating formation of a MIM capacitor cell insulator, in accordance with some embodiments;
FIG. 8A and 8B are cross-sectional and plan views illustrating formation of a MIM capacitor cell top electrode material, in accordance with some embodiments;
FIG. 9A and 9B are cross-sectional and plan views illustrating a MIM capacitor top cell interconnect material, in accordance with some embodiments;
FIG. 10A and 10B are cross-sectional and plan views illustrating a patterning of the MIM capacitor top cell interconnect structure, in accordance with some embodiments;
FIG. 11A and 11B are cross-sectional and plan views illustrating formation of terminal interconnects to MIM capacitor top and bottom cell interconnect structures, in accordance with some embodiments;
FIG. 12 is a cross-sectional view illustrating a microelectronic device assembly including an embedded or integrated MIM capacitor structure; in accordance with some embodiments;
FIG. 13 illustrates a mobile computing platform and a data server machine employing an IC including MIM capacitors, in accordance with some embodiments; and
FIG. 14 is a functional block diagram of an electronic computing device that may be included with a mobile or server computing platform, in accordance with some embodiments.

### DETAILED DESCRIPTION

Embodiments are described with reference to the enclosed figures. While specific configurations and arrangements are depicted and discussed in detail, this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. These terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements cooperate or interact with each other (e.g., as in a cause-and-effect relationship).

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

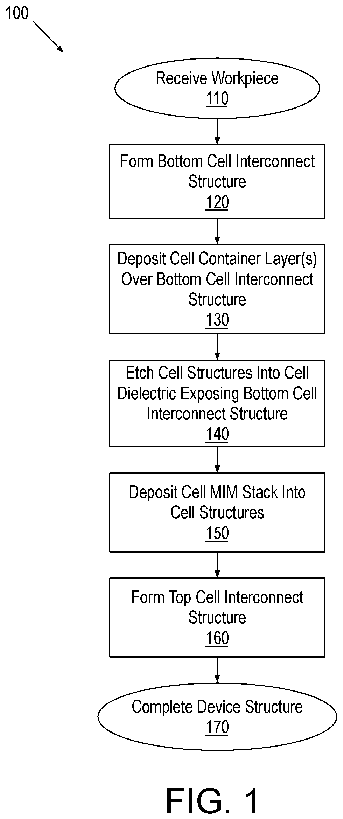

FIG. 1 is a flow diagram illustrating methods 100 for forming a MIM capacitor comprising a plurality of high-density cells interconnected in electrical parallel between two cell interconnect structures positioned above and below the cells. As described further below, the cell interconnect structures formed in methods 100 can reduce the electrical plate resistance of a MIM capacitor as these cell interconnect structures are free to be of any composition and/or thickness needed for a desired electrical resistivity. The cell interconnect structures are fabricated independent of a cell-level MIM stack and therefore do not have film thickness and/or film stress constraints associated with cell topography. As also further described, upper and lower cell interconnect structures are electrically coupled to separate metal films of a cell-level MIM stack and may electrically interconnect one cell-level metal film across any number of cells occupying an area spanned by the cell interconnect structure. As further described below, fabrication of cell interconnect structures in accordance with embodiments herein may also be further leveraged to introduce an etch stop layer for any features in a workpiece that are patterned concurrently with the cell features, such as workpiece alignment features utilized by lithography tooling, or the like.

Methods 100 begin at input 110 where a suitable workpiece, such as a semiconductor wafer (e.g., 300 mm diameter), or large format panel (e.g., 510 mm x 515 mm), is received. For one exemplary implementation where the workpiece is a large format panel, methods 100 are practiced to fabricate MIM capacitors in accordance with embodiments herein as an integral part of an IC die package fabrication flow. The IC die package may then be further assembled with one or more IC die. However, in other embodiments where the workpiece is a semiconductor wafer, methods 100 may be alternatively practiced to fabricate an IC die that similarly includes integrated MIM capacitors in accordance with embodiments herein. The IC die including the MIM capacitors may then be embedded within an IC die package that may then be further assembled with one or more IC die.

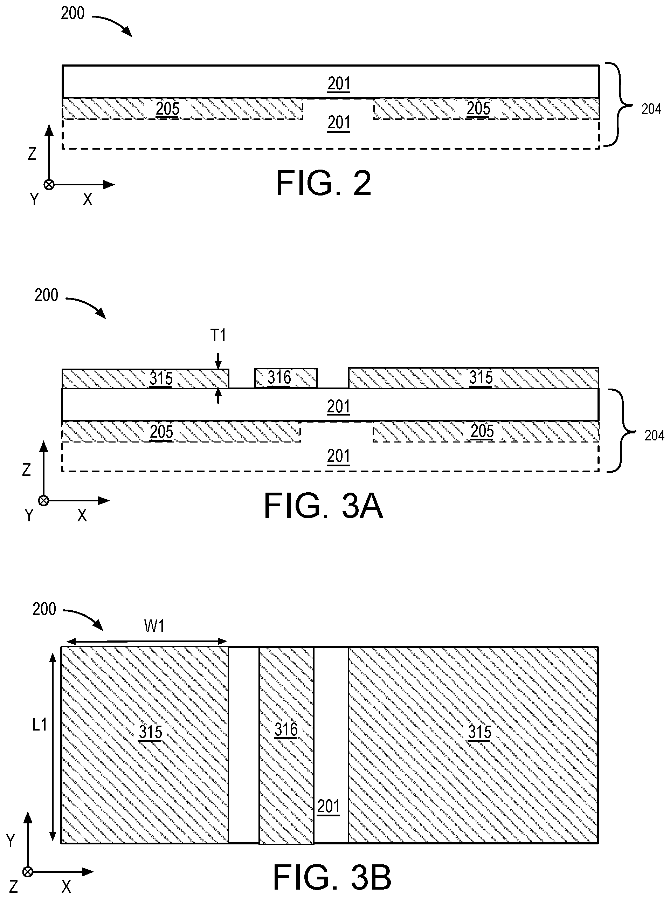

The workpiece may include any number of substrate structures fabricated upstream of methods 100 according to any known techniques. FIG. 2 is a cross-sectional view further illustrating an exemplary host device 200 that is to include a MIM capacitor, in accordance with some embodiments. Host device 200 includes a dielectric material 201 on a working surface. Below the uppermost layer of dielectric material 201, a substrate 204 may further include one or more levels of metallization features 205 embedded within one or more additional layers of dielectric material 201, which are illustrated in dashed line to emphasize there may be any number of underlying substrate structures and layers.

Substrate 204 may include a rigid core (not depicted) or may be a coreless substrate. In cored embodiments, layers of dielectric material 201 may have been built up on one or more side of a structural material layer, for example. In coreless embodiments, substrate 204 may comprise only dielectric material 201 and embedded routing metallization features 205. For cored embodiments, a core may be an epoxy-based laminate (e.g., FR4), silicon (e.g., monocrystalline) or glass. Glass cores may be predominantly silica (e.g., silicon and oxygen) and may further include one or more compositional additives, such as, aluminum, beryllium, magnesium, calcium, strontium barium, radium, tin, sodium, silver potassium, boron, phosphorus, zirconium, lithium, titanium, or zinc. A glass core may therefore be any of aluminosilicate, borosilicate, alumino-borosilicate, or silica, etc. A substrate core may be primarily silicon, oxygen, and aluminum, for example. In some advantageous embodiments, the substrate core is glass comprising at least 23 weight percent silicon and at least 26 weight percent oxygen, and further comprising at least 5 weight percent aluminum.

One or more layers of dielectric material 201 may be, for example, an organic dielectric, such as, an epoxy resin, phenolic-glass, or a resinous film such as the GX-series films commercially available from Ajinomoto Fine-Techno Co., Inc.(ABF). Dielectric material 201 may comprise epoxy resins (e.g., an acrylate of novolac such as epoxy phenol novolacs (EPN) or epoxy cresol novolacs (ECN)). In other examples, dielectric material 201 includes aliphatic epoxy resin, which may be monofunctional (e.g., dodecanol glycidyl ether), difunctional (butanediol diglycidyl ether), or have higher functionality (e.g., trimethylolpropane triglycidyl ether). One or more layers of dielectric material 201 may also be an inorganic dielectric material (e.g., comprising at least 20 atomic % of one or more of silicon, oxygen, or nitrogen). In some embodiments, the inorganic dielectric material is primarily silicon and oxygen (e.g., SiO₂), primarily silicon and nitrogen (e.g., Si₃N₂), or primarily silicon, oxygen and nitrogen (e.g., SiₓO_{y}Nₓ), any of which may further comprise one or more dopants, such as carbon. Inorganic dielectric materials are nevertheless distinct from organic dielectrics (e.g., epoxy resins and phenolic-glasses), which have much higher carbon content and a higher percentage of carbon-hydrogen bonds.

If present within substrate 204, metallization features 205 may comprise any metal known to be suitable for electrical interconnection, routing, and/or redistribution within an IC die package and/or IC die. Metallization features 205 may be predominantly Cu, for example, or another metal that may be similarly plated or otherwise deposited (e.g., by physical vapor deposition) at temperatures compatible with dielectric material 201 and/or other metallization features of substrate 204. One or more of metallization features 205 may be to electrically interface, for example through solder bumps (not depicted), to a next level of integration, such as a host board (not depicted).

Returning to FIG. 1, methods 100 continue at block 120 where one or more electrically conductive materials are deposited upon a dielectric surface of the workpiece received at input 110. Any number of layers of one or more conductive materials may be deposited by any known technique, such as physical vapor deposition (PVD) or plating. In some embodiments where a single conductive material layer is deposited, the conductive material is of a composition that has sufficiently high electrical conductivity at a desired film thickness. The conductive material may also offer good adhesion to the underlying dielectric and/or promote good adhesion with another material subsequently deposited in methods 100. In exemplary embodiments, one or more layers of an elemental metal or alloyed metal are deposited at block 120. Following deposition, the conductive material(s) are patterned into first, or bottom, cell interconnect structures, for example according to any lithographic patterning and thin film etch process compatible with the conductive material(s).

FIG. 3A and 3B are cross-sectional and plan views illustrating two MIM capacitor bottom cell interconnect structures 315, in accordance with some embodiments. In this example, a contiguous conductive material layer has been patterned into two adjacent cell interconnect structures 315. An intervening portion of the conductive material has been further patterned into a filler structure 316, for example to achieve a desired pattern density. In some exemplary embodiments, interconnect structures 315 are a metal, such as titanium (Ti) or a nitride thereof (TiN, e.g., primarily titanium and nitrogen). In other embodiments, each cell interconnect structure 315 is one or more of tungsten (W) or a nitride thereof (WN, e.g., primarily tungsten and nitrogen), or tantalum (Ta) or a nitride thereof (TaN, e.g., primarily tantalum and nitrogen). In other embodiments, cell interconnect structures 315 comprise one or more of ruthenium (Ru), iridium (Ir), aluminum (Al), copper (Cu), cobalt (Co), chromium (Cr), molybdenum (Mo), niobium (Nb) nickel (Ni), gold (Au), or platinum (Pt).

As illustrated, cell interconnect structures 315 may be substantially planar as a function of planarity in the working surface of substrate 204. Film stress can therefore be tolerated allowing cell interconnect structures 315 to have any thickness T₁ needed to achieve a desired electrical resistivity for a given conductive material composition. In some examples where cell interconnect structures 315 are one or more of the above metals, thickness T₁ is at least 10 nm, and may be 100-300 nm, or more. As illustrated in FIG. 3B, cell interconnect structures 315 may have ant length L and any width W, which defines a MIM capacitor footprint or area that is to be occupied by a MIM capacitor. Each discrete instance of a cell interconnect structure 315 may similarly define a discrete MIM capacitor structure. As further illustrated in FIG. 3B, one or more intervening conductive material structures 316 may between adjacent cell interconnect structures 315, for example to maintain a minimum pattern density and/or to facilitate electrical interconnection within substrate 204.

Returning to FIG. 1, methods 100 continue at block 130 where a cell container material is deposited over the bottom cell interconnect structures. The cell container material may be deposited to any thickness to subsequently define a height of cell container structures that are patterned into the cell container material. In exemplary embodiments, an inorganic dielectric material is deposited at block 130, for example with a chemical vapor deposition (CVD) process.

At block 140, cell structures are patterned into the material deposited at block 130. Any lithographic mask patterning process may be practiced at block 140 followed by any etch process suitable for translating the mask pattern into the underlying cell container material. In some exemplary embodiments, the etch process clears through the entire thickness of the cell container material, exposing and stopping on the underlying bottom cell interconnect structure.

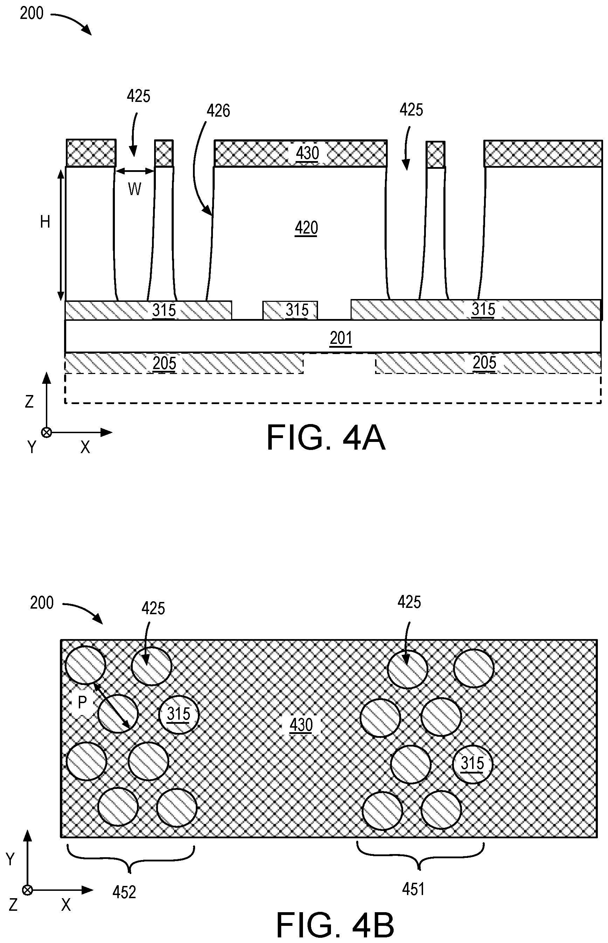

FIG. 4A and 4B are cross-sectional and plan views illustrating MIM capacitor cell structures, in accordance with some embodiments. In this example an etch mask 430 defines a plurality of openings 425 (e.g., holes or trenches) arrayed over the footprint of underlying bottom cell interconnect structures 315. A first opening array 451 is aligned over a first of bottom cell interconnect structures 315 and a second opening array 452 is aligned over a second of bottom cell interconnect structures 315. For exemplary embodiments where a cell container material 420 is an inorganic dielectric material, openings 425 may be plasma/dry etched with a fluorocarbon and/or halogen source gas to define a cell structure having a high aspect ratio (e.g., height H is 10 times width W) and a high opening density (e.g., 100 nm minimum feature pitch P). As shown, bottom cell interconnect structures 315 may advantageously function as an etch stop so that cell height H is well-defined across all capacitor cells and allowing the dielectric etch process to be optimized in terms of profile or slope of cell sidewall 426 without further constraints associated with etch depth uniformity. Although cell height H may vary with implementation, in some examples, cell height H is at least 0.5 µm and may be 3 µm, or more. Although openings 425 are illustrated in FIG. 4B as circular, elongated openings (i.e., trenches) may be similarly patterned. The 2D array of openings 425 may also have any alternative layout, for example to achieve a desired cell density.

As further described below, each opening 425 defines a container for one cell of a MIM capacitor. However, other openings 425 that are not ultimately incorporated into a MIM capacitor may be similarly fabricated concurrently with the MIM cell containers. For example, in other regions of a workpiece alignment features utilized by lithography tooling may be defined by other openings 425. For such embodiments, a bottom cell interconnect structure 315 may be similarly present and leveraged as an etch stop layer to ensure proper contrast for an alignment feature opening and/or to ensure the alignment feature opening is not so deep as to intersect an underlying substrate metallization feature 205.

Returning to FIG. 1, methods 100 continue at block 150 where a cell MIM material stack is deposited over, and into, the cell structures that were patterned at block 140. The cell MIM material stack may vary with implementation but includes at least two electrode material layers and an intervening insulator layer. The cell MIM material stack may be formed with one or more deposition techniques suitable for forming a liner on surfaces of the cell containers defined at block 140. In the presence of bottom cell interconnect structure 315, electrical conductivity requirements of a first electrode material layer of the MIM stack may be greatly reduced relative to an alternative MIM capacitor structure lacking bottom cell interconnect structure 315. The first electrode material of a MIM stack may therefore have a wide range of compositions and be of minimal thickness. With a reduction in electrode material layer thickness, MIM stack stress may be reduced and/or film adhesion improved to improve capacitor cell yields.

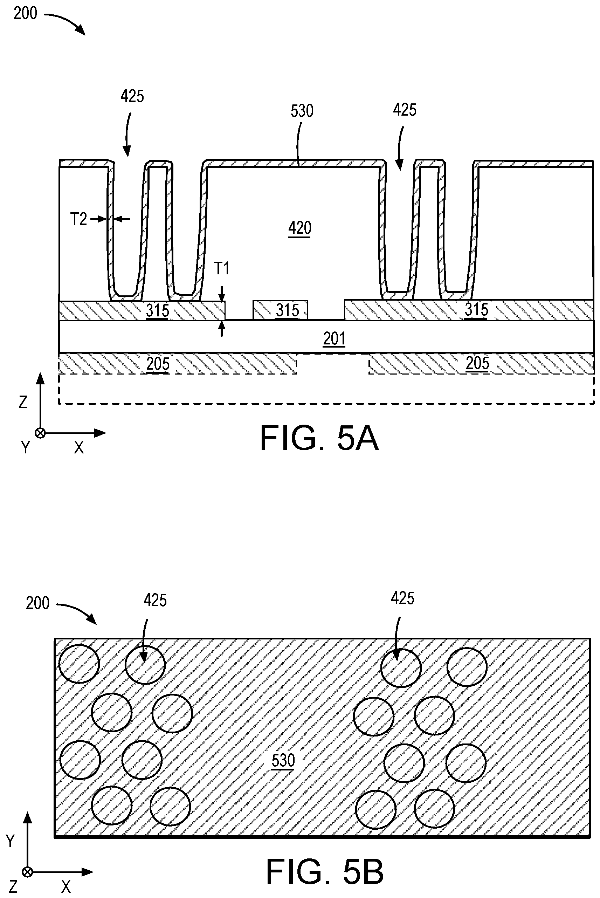

FIG. 5A and 5B are cross-sectional and plan views illustrating formation of a MIM capacitor cell bottom electrode material layer 530, in accordance with some embodiments. In this example, cell electrode material layer 530 makes direct contact with bottom cell interconnect structure 315 exposed at the bottom of each cell structure. Cell electrode material layer 530 may be deposited by any technique suitable for the workpiece, electrode material composition and aspect ratio of openings 425. In some examples, cell electrode material layer 530 is deposited with a PVD process. In other embodiments cell electrode material layer 530 is deposited with a low temperature (e.g., <400 °C) CVD or ALD process. Although cell electrode material layer 530 may have any thickness T₂, in exemplary embodiments, thickness T₂ is less than bottom cell interconnect thickness T₁. In some advantageous embodiments, cell electrode material layer thickness T2 is less than 1/3 of thickness T₁. Thickness T₂ may be, for example, less than 10 nm and can be 5 nm, or less (e.g., 2-4 nm).

The composition of cell electrode material layer 530 may vary but advantageously has good adhesion with bottom cell interconnect structure 315 and is compatible with an insulator layer of the cell MIM material stack. In some embodiments, cell electrode material layer 530 has the same composition as bottom cell interconnect structure 315. In other embodiments, the composition of electrode material layer 530 is different than that of bottom cell interconnect structure 315. In some examples, cell electrode material layer 530 comprises more nitrogen than bottom cell interconnect structure 315 as a reduction in conductivity associated with greater nitrogen can be tolerated in the present of bottom cell interconnect structure 315. For some embodiments, cell electrode material layer 530 is TiN. Both bottom cell interconnect structure 315 and electrode material layer 530 may therefore comprise Ti in some embodiments. In other embodiments, cell electrode material layer 530 comprises one or more of W or WN, or Ta or TaN. In still other embodiments, cell electrode material layer 530 includes one or more of Ru, Ir, Al, Cu, Co, Cr, Mo, Nb, Ni, Au, or Pt.

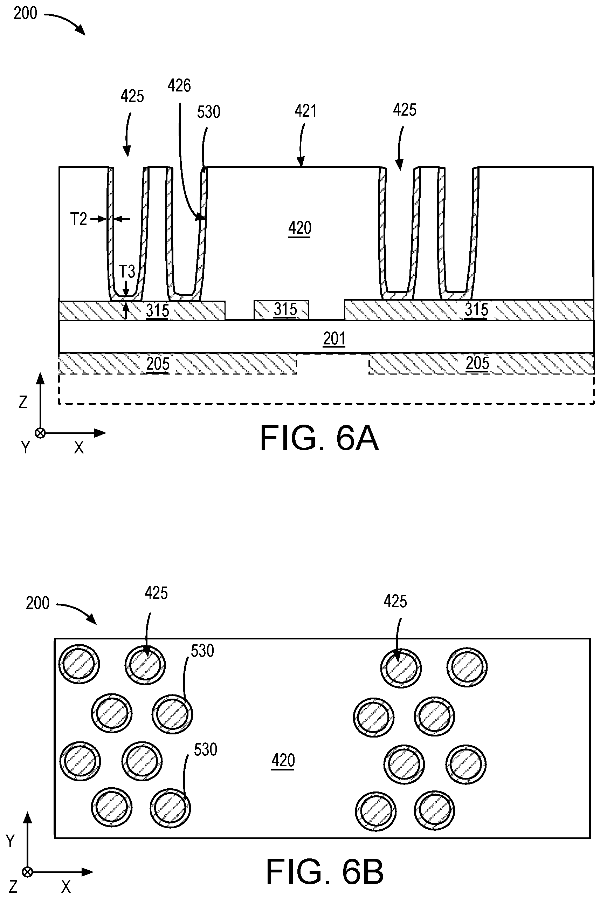

With cell electrode material layer 530 in direct contact with bottom cell interconnect structure 315, cell electrode material layer 530 need not span multiple cell structures and may instead be patterned so as to confine cell electrode material within the cell containers. FIG. 6A and 6B are cross-sectional and plan views illustrating a patterning of MIM capacitor cell electrode material 530 into discrete cell electrode structures that are confined within one opening 425, in accordance with some embodiments. Cell electrode material 530 has been removed from a top surface 421 of cell container material 420, for example with a planarization process, a planar etchback process, a facet etchback process (i.e., causing corners to become 45° edges) , or a back sputter process.

Prior to the planarization or etchback, a sacrificial material may be first deposited into openings 425, for example to ensure cell electrode material 530 retains thickness T₂ along cell sidewall 426 of each cell structure and/or to facilitate planarization, etc. At a bottom of each cell structure, cell electrode material 530 may also retain a non-zero thickness T₃. However, in some embodiments, for example where cell electrode material 530 is patterned with a blanket anisotropic etchback (i.e., a spacer etch), bottom cell electrode thickness T₃ may be zero (i.e. bottom cell interconnect structure 315 is exposed at a bottom of each cell). For such embodiments, only a cylinder of cell electrode material 530 may be retained as a liner along cell sidewall 426. Regardless, bottom cell interconnect structure 315 is to remain in direct contact with at least some portion of cell electrode material 530 that is retained within each overlying cell container. With a very low thickness T₂, electrical resistance of cell electrode material layer 530 can be expected to be relatively high regardless of composition. However, at approximately a center of each instance of cell electrode material 530 direct contact with made with bottom cell interconnect structure 315, which is of much lower electrical resistance and electrically couples each instance of cell electrode material 530 to a same electrical node voltage.

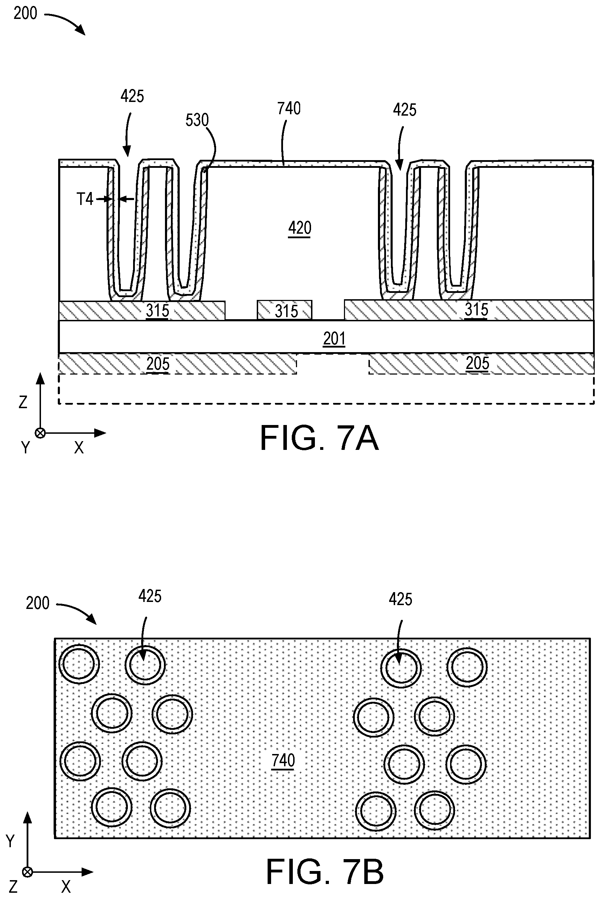

Following patterning of the bottom cell electrode, MIM stack formation may continue with deposition of an insulator. FIG. 7A and 7B are cross-sectional and plan views illustrating formation of a MIM insulator 740, in accordance with some embodiments. In some embodiments, a dielectric material is deposited with a PVD process or a low-temperature CVD process to a (sidewall) thickness T₄. Insulator thickness T₄ may vary with implementation. In some examples, insulator thickness T₄ is 1-20 nm, although other thicknesses may also be suitable, for example to sustain higher breakdown voltage thresholds, etc.

MIM insulator 740 may be of any composition having a suitable dielectric constant (relative permittivity). Although MIM insulator 740 may be a inorganic conventional dielectric, in some embodiments, MIM insulator 740 is of a composition and/or has particular material phase(s) resulting in high a dielectric constant (e.g., exceeding 9). Insulator 740 may be a crystalline film as deposited or following a subsequent thermal anneal. In some embodiments, the composition of insulator 740 is substantially homogeneous over thickness T₄. Insulator 740 may be any inorganic oxide (e.g., silica, silicon nitride, etc.) or may be a metal oxide, such as a perovskite oxide. In some examples, the perovskite oxide is a titanium oxide such as BTO (e.g., BaTiO₃), STO (e.g., SrTiO₃), or BSTO (e.g., BaSrTiO₃). In some other embodiments, the metal oxide is titanium oxide (TiO₂). In other embodiments, the metal oxide is fluorite binary oxide, such as zirconium oxide, ZrO₂ (i.e., a material consisting essentially of zirconium and oxygen), or hafnium oxide, HfO₂ (i.e., a material including hafnium and oxygen). In some zirconium oxide embodiments, the zirconium oxide is approximately stoichiometric having not less than thirty atomic percent zirconium and not less than sixty atomic percent oxygen. In some hafnium oxide embodiments, the hafnium oxide is approximately stoichiometric hafnium oxide having not less than thirty atomic percent hafnium and not less than sixty atomic percent oxygen. In other examples, the metal oxide is a compound of Zr, Hf and oxygen.

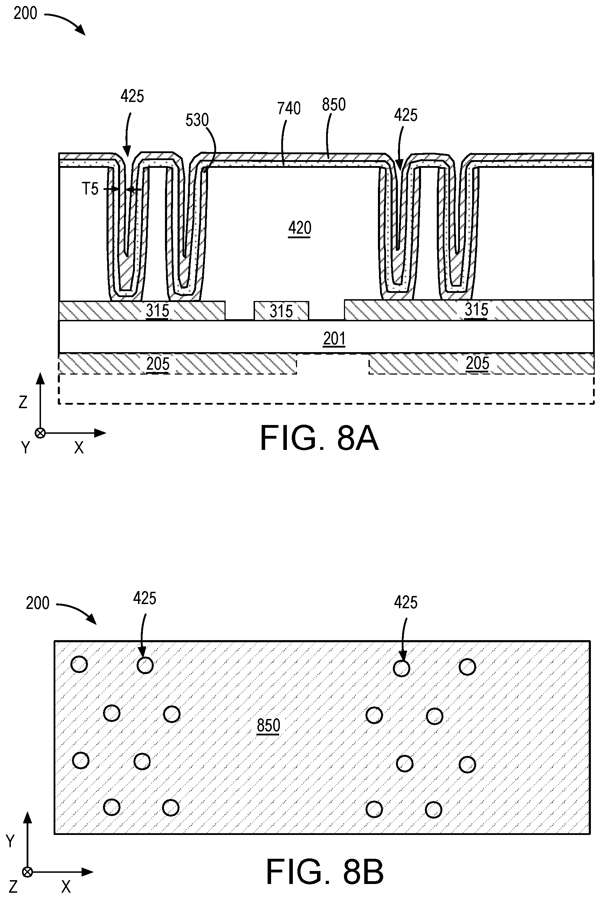

Following deposition of the MIM insulator, MIM material stack formation may be completed with deposition of another cell electrode material. FIG. 8A and 8B are cross-sectional and plan views illustrating formation of a MIM capacitor cell electrode material layer 850, in accordance with some embodiments. As shown, cell electrode material layer 850 has been deposited in direct contact with MIM insulator 740. Cell electrode material layer 850 may be deposited by any technique suitable for the workpiece, electrode material composition, and residual aspect ratio of openings 425. In some examples, cell electrode material layer 850 is deposited with a PVD process. In other embodiments cell electrode material layer 850 is deposited with a low temperature CVD or ALD process. Although cell electrode material layer 850 may have any thickness T₅, in exemplary embodiments, thickness T₅ is less than bottom cell interconnect thickness T₁, may be 2-5 nm for example In some advantageous embodiments, cell electrode material layer thickness T₅ is substantially the same as thickness T₂ of cell electrode material layer 530.

The composition of cell electrode material layer 850 may vary but advantageously has good adhesion with MIM insulator 740. In some embodiments, cell electrode material layer 850 has the same composition as cell electrode material layer 530. In other embodiments, the composition of electrode material layer 850 is different than that of electrode material layer 530. In some embodiments, cell electrode material layer 850 comprises nitrogen (e.g., more nitrogen than bottom cell interconnect structure 315). In some examples, cell electrode material layer 850 comprises Ti. All of bottom cell interconnect structure 315, electrode material layer 530 and electrode material layer 850 may therefore comprise Ti in some embodiments. In other embodiments, cell electrode material layer 850 comprises one or more of W or WN, or Ta or TaN. In still other embodiments, cell electrode material layer 850 includes one or more of Ru, Ir, Al, Cu, Co, Cr, Mo, Nb, Ni, Au, or Pt.

Returning to FIG. 1 with the MIM stack completed, methods 100 continue at block 160 where a top cell interconnect material is deposited and then patterned into discrete structures. Noting the electrical resistance of a top MIM electrode material layer may be high because of other constraints, a top cell interconnect material layer may be additionally deposited to reduce the effective resistance of a second capacitor electrode. At block 160 one or more electrically conductive materials of a different composition than the underlying MIM electrode material layer may be deposited by any known technique, such as PVD or plating. In some embodiments a single conductive material layer is deposited at block 160 and is of a composition that has higher electrical conductivity than the underlying MIM electrode material layer and good adhesion to the underlying MIM electrode material layer. In exemplary embodiments, an elemental metal or alloyed metal is deposited at block 160.

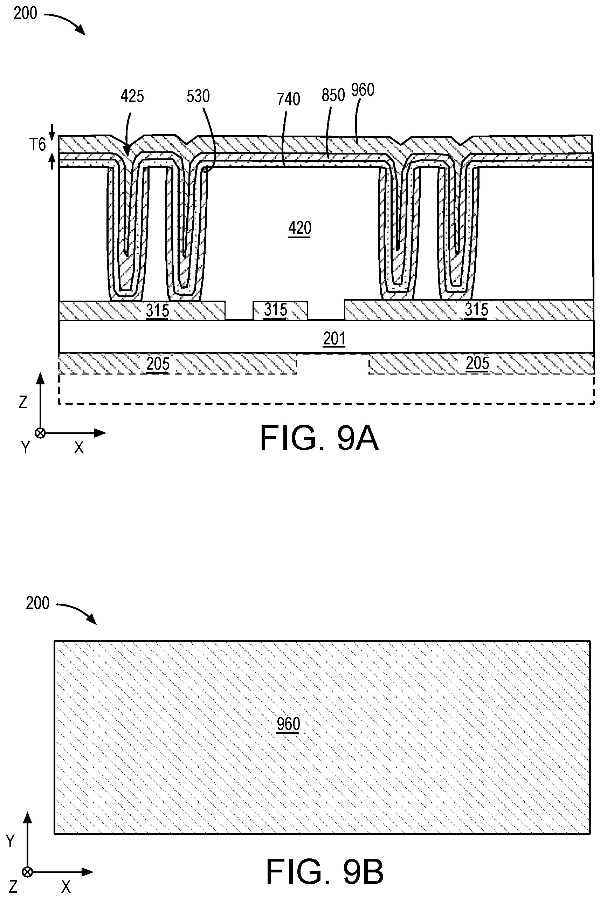

FIG. 9A and 9B are cross-sectional and plan views illustrating cell top interconnect material 960, in accordance with some embodiments. In this example, cell interconnect material 960 has been deposited in direct contact with MIM cell electrode material layer 850. Cell interconnect material 960 may have any thickness T₆ needed to achieve a desired electrical resistivity as a function of the conductive material composition. In some examples where cell interconnect material 960 is one or more of the metals listed below, thickness T₆ is at least three times the thickness T₅. In some embodiments, thickness T₆ is at least 50 nm, and may be 100-300 nm, or more.

Cell interconnect material 960 may substantially fill any remaining volume within openings 425, as illustrated. Alternatively, a less conformal deposition technique may result in cell interconnect material 960 occluding voids (not depicted) within openings 425 located between MIM cell electrode material layer 850 and top interconnect material 960. In some embodiments, top interconnect material 960 has the same composition as bottom interconnect structures 315. In other embodiments, top interconnect material 960 has a different composition than bottom interconnect structures 315. In some embodiments, top interconnect material 960 comprises less nitrogen than cell electrode material layer 850. In some examples, top interconnect material 960 comprises Ti. All of bottom cell interconnect structure 315, electrode material layer 530, electrode material layer 850 and top interconnect material 960 may therefore comprise Ti in some embodiments. In some other embodiments, top interconnect material 960 comprises one or more of W, Ta, Ru, Ir, Al, Cu, Co, Cr, Mo, Nb, Ni, Au, or Pt.

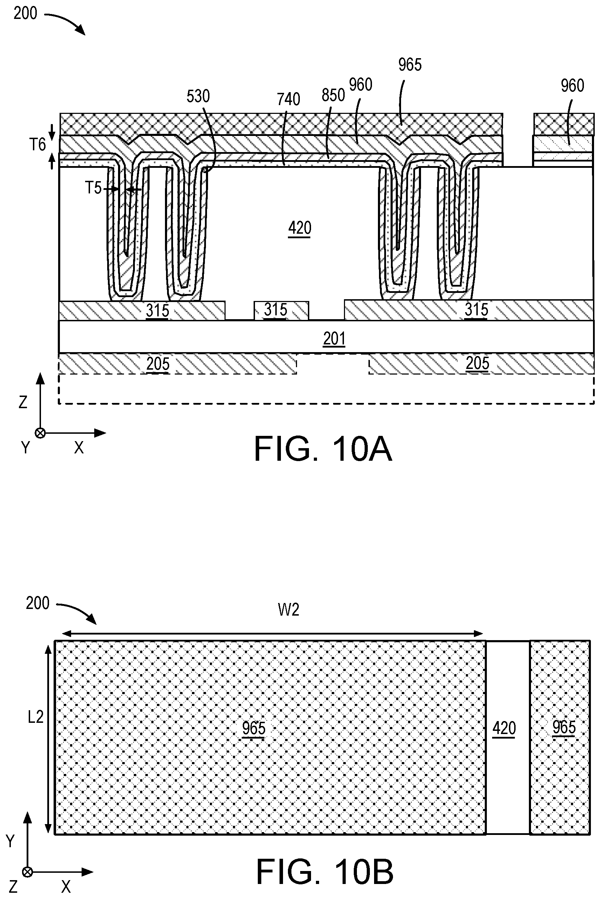

Cell interconnect material 960 may be patterned into second, or top, cell interconnect structures, for example according to any lithographic patterning and thin film etch processes compatible with the conductive material(s). FIG. 10A and 10B are cross-sectional and plan views illustrating two adjacent MIM capacitor top cell interconnect structures defined according to a mask material 965. As shown, an etch process has removed unmasked portions of cell interconnect material 960 as well as underlying cell electrode material 850. MIM insulator 740 may also be removed, for example during an overetch, to expose cell container material 420.

As illustrated in FIG. 10B, an individual cell interconnect structure may span the entirety of one or more arrays of MIM capacitor cells, coupling all underlying cells in electrical parallel to a same capacitor plate voltage. One cell interconnect structure may have any length L₂ and any width W₂, which defines another MIM capacitor footprint of area that is to be coupled together by a single capacitor plate. As further shown in FIG. 10, a top cell interconnect structure may overlap MIM cell structures coupled to separate cell interconnect structures 315 to arrive at any desired interconnection of MIM capacitor plates.

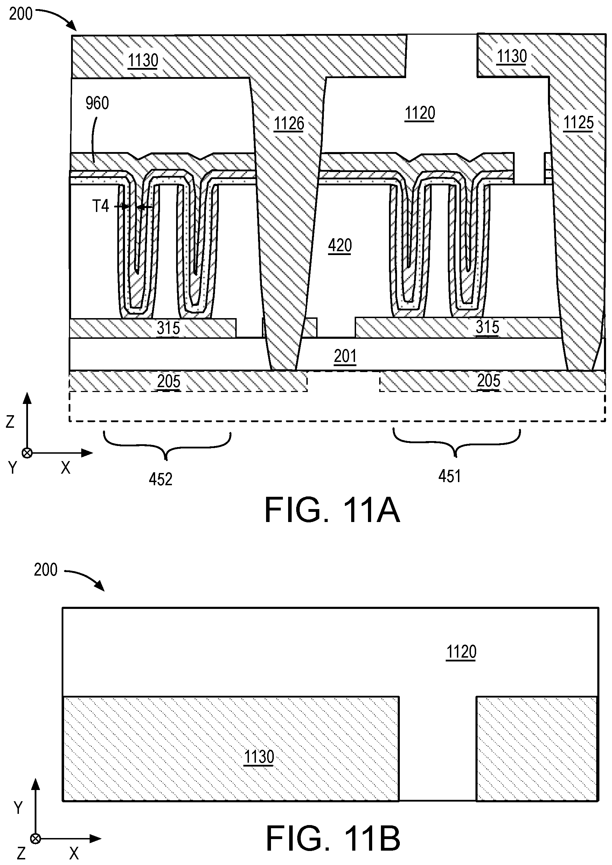

Returning to FIG. 1 with the MIM capacitors now fabricated, methods 100 end at output 170 where any device structures may be completed. In exemplary IC die package embodiments, the device structure may be completed by fabricating additional levels of routing metallization. The routing metallization may, for example, interconnect one or more IC die to terminals of the underlying MIM capacitors. Such routing metallization levels may be fabricated according to any known techniques, including semi-additive processing (SAP) techniques, damascene metallization techniques, etc. FIG. 11A and 11B are cross-sectional and plan views illustrating MIM capacitor terminal interconnects coupling to cell interconnect structures 315 and 960. As shown, a first terminal interconnect comprises a first conductive via 1125 extending from a routing metallization level 1130 that is overlying the MIM capacitor level and down to a first bottom MIM interconnect structure 315 associated with MIM capacitor array 451. In this example, conductive via 1125 further extends to an underlying substrate metallization feature 205.

MIM terminal interconnects further comprise a second conductive via 1126 extending from metallization level 1130, through dielectric material 1120, and to a top MIM interconnect structure 960 that is electrically coupled to both the MIM capacitor array 451 and MIM capacitor array 452. In this example, conductive via 1126 further extends to another substrate metallization feature 205, but does not intersect any intervening bottom MIM interconnect structure 315. The top plate terminals of two capacitor arrays 451, 452 are interconnected to a same circuit node while the bottom plate terminals of capacitor arrays 451, 452 are coupled to different circuit nodes. MIM interconnect structures in accordance with embodiments herein may therefore not only interconnect any number MIM cells in electrical parallel but may also interconnect a plate of a plurality of MIM capacitor arrays in electrical parallel by spanning any distance between individual arrays.

The MIM capacitor structures described above, and the methods of forming such structures described herein, may be integrated into a wide variety of ICs and devices that include such ICs. For example, MIM capacitor structures incorporated in IC power supply circuitry may include the low resistance MIM structures described above. An IC power supply may include switching capacitors or bypass (decoupling) capacitors tasked with removing voltage ripples and either of these types of capacitors may be implemented (e.g., either within an IC die or within a package substrate of an IC die).

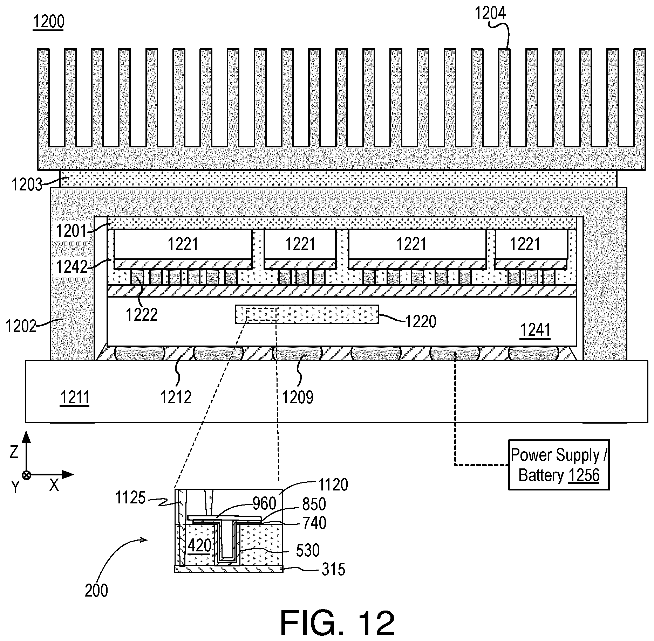

FIG. 12 is a cross-sectional view illustrating a microelectronic device assembly 1200, which includes a high-density MIM capacitor structure within an IC die package, in accordance with some embodiments. Microelectronic device assembly 1200 includes a plurality of IC dies 1221 joined to package substrate 1241 with die-level interconnects 1222 and optionally embedded in a mold material 1242. However, any single IC die, 3D stacked multichip device, multi-chip composite structure, or the like may be similarly assembled within microelectronic device assembly 1200.

A thermal interface material (TIM) 1201 is between IC dies 1221 and a heat spreader and/or lid 1202, which extends beyond a perimeter of package substrate 1241, and is mounted to board 1211. Another TIM 1203 is between lid (heat spreader) 1202 and a thermal dissipation device 1204, which may be a heat sink, heat pipe or other thermal solution.

Package substrate 1241 is coupled to a board 1211 with package-level interconnects 1209 (e.g., solder features) that may be at least partially surrounded by underfill material 1212. Board 1211 may include any suitable substrate such as a motherboard, interposer, or the like. Microelectronic device assembly 1200 is coupled to a power supply 1256, for example through one or more of board 1211 and package substrate 1241. Power supply 1256 may include a battery and multi-rail power supply circuitry, such as a switching supply with a voltage converter, etc.

Package substrate 1241 may comprise one or more insulator layers and routing metallization layers. Insulator layers may be a portion of a package substrate or a build-up layer over or on the package substrate. In some embodiments, package substrate 1241 includes an inorganic substrate material, such as glass. For example, package substrate 1241 may include a layer of bulk glass, such as any of those described above in the context of substrate 204. In some embodiments, the layer of bulk glass is rectangular in shape in a plan view. However, the bulk glass may have other shapes. In some embodiments, substrate 1241 has a thickness in the range of 50 µm to 1.4 mm (i.e., in the z-direction).

As shown in FIG. 12, a power supply component 1220 is embedded within package substrate 1241. In exemplary embodiments, power supply component 1220 comprises device 200 that further includes a MIM capacitor structure, for example substantially as described elsewhere herein. In this example, MIM capacitor array structures comprise openings 425 that are defined in a portion of substrate 1241. Openings 425 may, for example, extend partially or entirely through a thickness of a glass core or other material layer of substrate 1241. MIM capacitor array structures including MIM cell interconnect structures 315 and/or 960 are therefore part of an integrated device 200, for example suitable as a power supply coupling capacitor, etc. In other examples, device 200 includes MIM capacitor array structures with openings 425 that are defined in a portion of IC die separate from package substrate 1241. Openings 425 may, for example, extend partially or entirely through a thickness of a dielectric material layer of the IC die. MIM capacitor array structures including MIM cell interconnect structures 315 and/or 960 are therefore part of an IC die that is embedded within substrate 1241 (e.g., as a preform placed within a recess of substrate 1241). For such embodiments, device 200 can be similarly configured as a power supply coupling capacitor, etc.

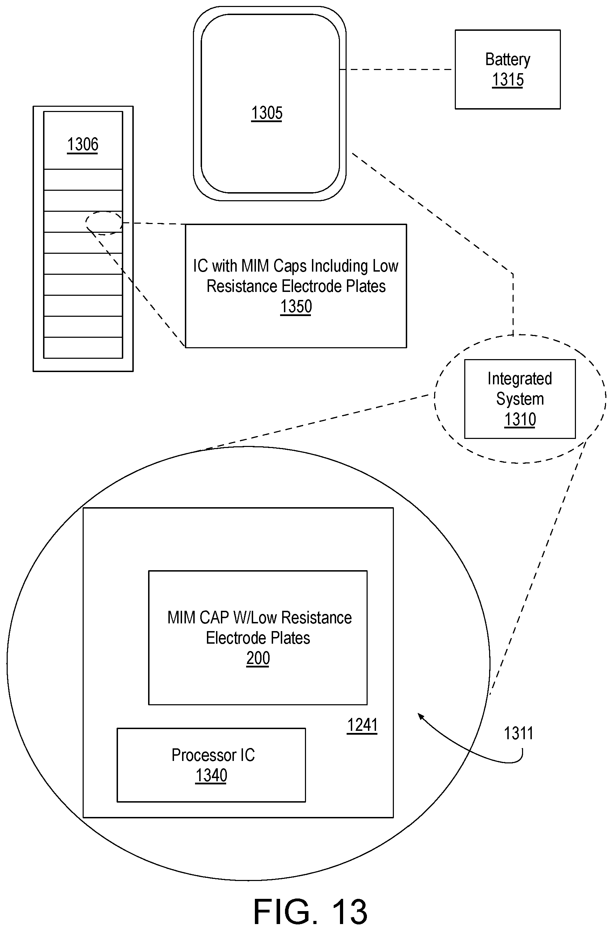

The various MIM capacitor structures, and methods of forming such structures, described herein may be integrated into a wide variety of IC packages and systems that include such IC packages. FIG. 13 illustrates a system in which a mobile computing platform 1305 and/or a data server machine 1306 includes a packaged IC die 1350 comprising a MIM capacitor with one or more MIM cell interconnect structures in accordance with one or more of the embodiments described elsewhere herein. The server machine 1306 may be any commercial server, for example including any number of high-performance computing platforms within a rack and networked together for electronic data processing. The mobile computing platform 1305 may be any portable device configured for each of electronic data display, electronic data processing, wireless electronic data transmission, or the like. For example, the mobile computing platform 1305 may be any of a tablet, a smart phone, laptop computer, etc., and may include a display screen (e.g., a capacitive, inductive, resistive, or optical touchscreen), an IC die package integrated system 1310, and a battery 1315.

Whether disposed within the integrated system 1310 further illustrated in the expanded view 1311, or as a stand-alone chip within the server machine 1306, packaged IC die 1350 may include memory circuitry (e.g., RAM), and/or a logic circuitry (e.g., a microprocessor, a multi-core microprocessor, graphics processor, or the like). At least one of these circuitries comprises a MIM capacitor structure including one or more MIM cell interconnect structure in accordance with one or more embodiments described elsewhere herein. Integrated systems 1310 may include a package substrate 1241 that hosts one or more ICs, such as a processor IC 1340. Package substrate 1241 further hosts device 200 including a MIM capacitor array including one or more of the features or attributes described elsewhere herein.

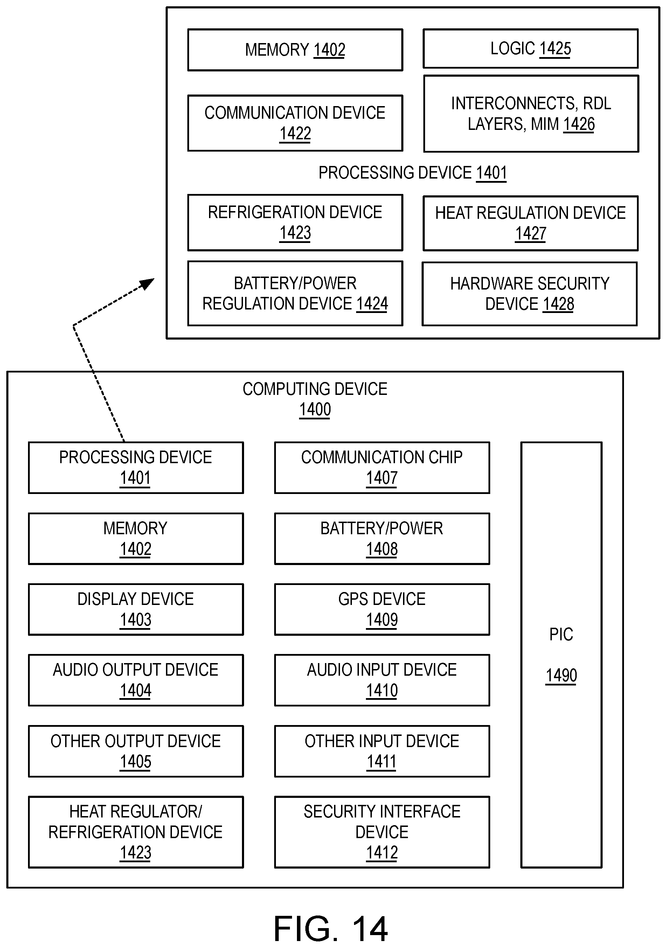

FIG. 14 is a block diagram of a computing device 1400 in accordance with some embodiments. For example, one or more components of computing device 1400 may include any of the MIM array structures discussed elsewhere herein. A number of components are illustrated in FIG. 14, but any one or more of these components may be omitted or duplicated, as suitable for the application. In some embodiments, some of the components included in computing device 1400 may be attached to one or more printed circuit boards (e.g., a motherboard). In some embodiments, various ones of these components may be fabricated onto a single system-on-a-chip (SoC) die or implemented with a disintegrated plurality of chiplets or tiles packaged together. Additionally, in various embodiments, computing device 1400 may not include one or more of the components illustrated in FIG. 14, but computing device 1400 may include interface circuitry for coupling to the one or more components. For example, computing device 1400 may not include a display device 1403, but may include display device interface circuitry (e.g., a connector and driver circuitry) to which display device 1403 may be coupled.

Computing device 1400 may include a processing device 1401 (e.g., one or more processing devices). As used herein, the term processing device or processor indicates a device that processes electronic data from registers and/or memory to transform that electronic data into other electronic data that may be stored in registers and/or memory. Processing device 1401 may include a memory 1402, a communication device 1422, a refrigeration/active cooling device 1423, a battery/power regulation device 1424, logic 1425, interconnects 1426, a heat regulation device 1427, and a hardware security device 1428.

Processing device 1401 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable compute units.

Processing device 1401 may include a memory 1402, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, processing device 1401 shares a package with memory 1402. This memory may be used as cache memory and may include embedded dynamic random-access memory (eDRAM) or spin transfer torque magnetic random-access memory (STT-M RAM).

Computing device 1400 may include a heat regulation/refrigeration device 1423. Heat regulation/refrigeration device 1423 may maintain processing device 1401 (and/or other components of computing device 1400) at a predetermined low temperature during operation. This predetermined low temperature may be any temperature discussed elsewhere herein.

In some embodiments, computing device 1400 may include a communication chip 1407 (e.g., one or more communication chips). For example, the communication chip 1407 may be configured for managing wireless communications for the transfer of data to and from computing device 1400. The term "wireless" and its derivatives may be used to describe circuits, devices, systems, methods, techniques, communications channels, etc., that may communicate data through the use of modulated electromagnetic radiation through a nonsolid medium.

Computing device 1400 includes a PIC 1490, for example having a photonic integrated WDM source circuit. PIC 1490 may facilitate communication between one or more instances of processing device 1401 and/or one or more instances of memory 1402, for example.

Computing device 1400 may include battery/power circuitry 1408. Battery/power circuitry 1408 may include one or more energy storage devices (e.g., batteries or capacitors) and/or circuitry for coupling components of computing device 1400 to an energy source separate from computing device 1400 (e.g., AC line power).

Computing device 1400 may include a display device 1403 (or corresponding interface circuitry, as discussed above). Display device 1403 may include any visual indicators, such as a heads-up display, a computer monitor, a projector, a touchscreen display, a liquid crystal display (LCD), a light-emitting diode display, or a flat panel display, for example.

Computing device 1400 may include an audio output device 1404 (or corresponding interface circuitry, as discussed above). Audio output device 1404 may include any device that generates an audible indicator, such as speakers, headsets, or earbuds, for example.

Computing device 1400 may include an audio input device 1410 (or corresponding interface circuitry, as discussed above). Audio input device 1410 may include any device that generates a signal representative of a sound, such as microphones, microphone arrays, or digital instruments (e.g., instruments having a musical instrument digital interface (MIDI) output).

Computing device 1400 may include a global positioning system (GPS) device 1409 (or corresponding interface circuitry, as discussed above). GPS device 1409 may be in communication with a satellite-based system and may receive a location of computing device 1400.

Computing device 1400 may include another output device 1405 (or corresponding interface circuitry, as discussed above). Examples include an audio codec, a video codec, a printer, a wired or wireless transmitter for providing information to other devices, or an additional storage device.

Computing device 1400 may include another input device 1411 (or corresponding interface circuitry, as discussed above). Examples may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1400 may include a security interface device 1412. Security interface device 1412 may include any device that provides security measures for computing device 1400 such as intrusion detection, biometric validation, security encode or decode, managing access lists, malware detection, or spyware detection.

Computing device 1400, or a subset of its components, may have any appropriate form factor, such as a server or other networked computing component, a mobile device, a printer, a scanner, a monitor, a set-top box, an entertainment control unit, a vehicle control unit, a digital camera, a digital video recorder, or a wearable computing device.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that embodiments described herein may be practiced with modification and alteration without departing from the scope of the appended claims. For example, the above embodiments may include specific combinations of features as further provided below.

In first examples, an apparatus comprises a cell interconnect structure comprising a first electrically conductive material of a first area. The apparatus comprises a dielectric material over the cell interconnect structure. The apparatus comprises one or more arrays of capacitor cells over the cell interconnect structure. Each of the arrays of capacitor cells comprises a second electrically conductive material in contact with the first electrically conductive material and on a sidewall of individual recesses within the dielectric material, but absent from a portion of the dielectric material between adjacent ones of the recesses. Each of the arrays of capacitor cells comprises an electrical insulator within the recesses and in contact with the second electrically conductive material, and a third electrically conductive material within the recesses.

In second examples, for any of the first examples the cell interconnect structure is a first cell interconnect structure and the apparatus further comprises a second cell interconnect structure. The second cell interconnect structure comprises a fourth electrically conductive material of a second area overlapping at least some of the arrays of capacitor cells and spanning the portion of the dielectric material between adjacent ones of the recesses.

In third examples, for any of the second examples the fourth electrically conductive material is in direct contact with the third electrically conductive material, and the third and fourth electrically conductive materials span the second area.

In fourth examples, for any of the third examples the first electrically conductive material has a first composition and a first thickness, the second electrically conductive material has a second composition and a second thickness, the third electrically conductive material has a third composition and a third thickness, and the fourth electrically conductive material has a fourth composition and a fourth thickness. The first composition is different than at least one of the second composition or the third composition, and the first thickness is greater than at least one of the second thickness or the third thickness.

In fifth examples, for any of the fourth examples the first composition is different than the second composition, and the first thickness is at least three times the second thickness.

In sixth examples, for any of the fifth examples the second thickness is less than 10 nm.

In seventh examples, for any of the fourth through sixth examples the second and third conductive materials each comprise at least one of Ti, W, Ta, Ru, Ir, Al, Cu, Co, Cr, Mo, Nb, Ni, Au, or Pt.

In eighth examples, for any of the seventh examples the first conductive material has less nitrogen than the second conductive material.

In ninth examples, for any of the second through eighth examples the apparatus further comprises a first conductive via in contact with the first cell interconnect structure and a second conductive via in contact with the second cell interconnect structure, wherein the first and second conductive vias both comprise Cu.

In tenth examples, for any of the second through ninth examples the arrays of capacitor cells comprise a first array adjacent to a second array, the first cell interconnect structure is under the first array, the second cell interconnect structure is over the first array and the second array, and a third cell interconnect structure comprising the first electrically conductive material of a third area is under the second array.

In eleventh examples, an apparatus comprises an integrated circuit (IC) die, and a package substrate coupled to the IC die. The package substrate comprises a metal-insulator-metal (MIM) capacitor structure, the MIM capacitor structure comprising a first electrically conductive material of a first area, a dielectric material over the first area, and an array of capacitor cells over the first area. The array comprises a second electrically conductive material in contact with the first electrically conductive material and on a sidewall of individual recesses within the dielectric material, but absent from a portion of the dielectric material between adjacent ones of the recesses. The array comprises an electrical insulator within the recesses and in contact with the second electrically conductive material, a third electrically conductive material within the recesses and in contact with the electrical insulator, and a fourth electrically conductive material of a second area and over at least a portion of the first area, the fourth electrically conductive material in direct contact with at least a portion of the third electrically conductive material.

In twelfth examples, for any of the eleventh examples the first and fourth conductive materials are both at least three times thicker than each of the second and third conductive materials.

In thirteenth examples, for any of the twelfth examples the first and fourth conductive materials both comprise less nitrogen than each of the second and third conductive materials.

In fourteenth examples, for any of the thirteenth examples the first and second conductive materials both comprise Ti.

In fifteenth examples, for any of the fourteenth examples the third and fourth conductive materials both comprise Ti.

In sixteenth examples, for any of the eleventh through fifteenth examples the plurality of capacitor cells comprise a first array of cells adjacent to a second array cell, a first cell interconnect structure comprising the first electrically conductive material is under the first array of cells, and a second cell interconnect structure the first electrically conductive material is under the second array of cells. The fourth electrically conductive material is over the first array and over the second array.

In seventeenth examples, for any of the sixteenth examples the apparatus comprises a first conductive via in contact with the first cell interconnect structure and a second conductive via in contact with the fourth conductive material. The first conductive via comprises Cu.

In eighteenth examples, a method comprises depositing a first conductive material over a first area of a substrate, depositing a dielectric material over the first conductive material, patterning a plurality of recesses through the dielectric material and exposing portions of the first conductive material, depositing a second conductive material within the recesses to a lesser thickness than the first conductive material, and removing the second conductive material from between the recesses. The method comprises depositing an insulator within the recesses and in contact with the second conductive material, depositing a third conductive material within the recesses, and forming a first capacitor terminal coupled to the first conductive material and a second capacitor terminal coupled to the third conductive material.

In nineteenth examples, for any of the eighteenth examples removing the portion of the second conductive material comprises a planarization process, planar etchback process, faceted etchback process, or physical sputter process that exposes the dielectric material.

In twentieth examples, for any of the eighteenth through nineteenth examples the method further comprises depositing a fourth conductive material in contact with the third conductive material, and to a greater thickness than the third conductive material.

However, the above embodiments are not limited in this regard and, in various implementations, the above embodiments may include the undertaking of only a subset of such features, undertaking a different order of such features, undertaking a different combination of such features, and/or undertaking additional features than those features explicitly listed. The scope of the invention should, therefore, be determined with reference to the appended claims.

## Claims

1. An apparatus, comprising:
a cell interconnect structure comprising a first electrically conductive material of a first area;
a dielectric material over the cell interconnect structure; and
one or more arrays of capacitor cells over the cell interconnect structure, wherein each of the arrays of capacitor cells comprises:
a second electrically conductive material in contact with the first electrically conductive material and on a sidewall of individual recesses within the dielectric material, but absent from a portion of the dielectric material between adjacent ones of the recesses; and
an electrical insulator within the recesses and in contact with the second electrically conductive material; and
a third electrically conductive material within the recesses.

2. The apparatus of claim 1, wherein:
the cell interconnect structure is a first cell interconnect structure and the apparatus further comprises a second cell interconnect structure; and
the second cell interconnect structure comprises a fourth electrically conductive material of a second area overlapping at least some of the arrays of capacitor cells and spanning the portion of the dielectric material between adjacent ones of the recesses.

3. The apparatus of claim 2, wherein:
the fourth electrically conductive material is in direct contact with the third electrically conductive material; and
the third and fourth electrically conductive materials span the second area.

4. The apparatus of claim 3, wherein:
the first electrically conductive material has a first composition and a first thickness;
the second electrically conductive material has a second composition and a second thickness;
the third electrically conductive material has a third composition and a third thickness;
the fourth electrically conductive material has a fourth composition and a fourth thickness; and
the first composition is different than at least one of the second composition or the third composition; and
the first thickness is greater than at least one of the second thickness or the third thickness.

5. The apparatus of claim 4, wherein:
the first composition is different than the second composition; and
the first thickness is at least three times the second thickness.

6. The apparatus of claim 5, wherein the second thickness is less than 10 nm.

7. The apparatus of any one of claims 4-6, wherein second and third conductive materials each comprise at least one of Ti, W, Ta, Ru, Ir, Al, Cu, Co, Cr, Mo, Nb, Ni, Au, or Pt.

8. The apparatus of claim 7, wherein the first electrically conductive material has less nitrogen than the second conductive material.

9. The apparatus of any one of claims 2-6, further comprising a first conductive via in contact with the first cell interconnect structure and a second conductive via in contact with the second cell interconnect structure, wherein the first and second conductive vias both comprise Cu.

10. The apparatus of any one of claims 2-6, wherein:
the arrays of capacitor cells comprise a first array adjacent to a second array;
the first cell interconnect structure is under the first array;
the second cell interconnect structure is over the first array and the second array; and
a third cell interconnect structure comprising the first electrically conductive material of a third area is under the second array.

11. An apparatus, comprising:
an integrated circuit (IC) die; and
a package substrate coupled to the IC die, wherein the package substrate comprises a metal-insulator-metal (MIM) capacitor structure, the MIM capacitor structure comprising:
a first electrically conductive material of a first area;
a dielectric material over the first area;
an array of capacitor cells over the first area, wherein the array comprises:
a second electrically conductive material in contact with the first electrically conductive material and on a sidewall of individual recesses within the dielectric material, but absent from a portion of the dielectric material between adjacent ones of the recesses; and
an electrical insulator within the recesses and in contact with the second electrically conductive material; and
a third electrically conductive material within the recesses and in contact with the electrical insulator; and
a fourth electrically conductive material of a second area and over at least a portion of the first area, the fourth electrically conductive material in direct contact with at least a portion of the third electrically conductive material.

12. The apparatus of claim 11, wherein the first and fourth electrically conductive materials are both at least three times thicker than each of the second and third conductive materials.

13. The apparatus of claim 12, wherein:
the first and fourth conductive materials both comprise less nitrogen than each of the second and third conductive materials; and
the first and second conductive materials both comprise Ti and the third and fourth conductive materials both comprise Ti.

14. The apparatus of any one of claims 11-13, wherein:
the array of capacitor cells comprise a first array of cells adjacent to a second array cells;
a first cell interconnect structure comprising the first electrically conductive material is under the first array of cells, and a second cell interconnect structure the first electrically conductive material is under the second array of cells; and
the fourth electrically conductive material is over the first array and over the second array.

15. The apparatus of claim 14, further comprising a first conductive via in contact with the first cell interconnect structure and a second conductive via in contact with the fourth conductive material, wherein the first conductive via comprises Cu.
